# EUROPEAN PATENT SPECIFICATION

(11) **EP 3 282 450 B1**
(45) Date of publication and mention of the grant of the patent: **08.04.2020**
(21) Application number: 16187315.3
(22) Date of filing: 06.09.2016
(51) Int. Cl.: G11C 17/18, G11C 17/16, G11C 5/14

(54) **MEMORY SYSTEM WITH SMALL SIZE ANTIFUSE CIRCUIT CAPABLE OF BOOSTING VOLTAGE**
SPEICHERSYSTEM MIT KLEINER ANTIFUSE-SCHALTUNG ZUR VERSTÄRKUNG DER SPANNUNG
SYSTÈME DE MÉMOIRE À CIRCUIT ANTIFUSIBLE DE PETITE TAILLE CAPABLE D'AMPLIFIER LA TENSION

(30) Priority: 11.08.2016 US 201615233970
(43) Date of publication of application: 14.02.2018
(73) Proprietor: eMemory Technology Inc., Hsin-Chu 300 (TW)
(72) Inventor: Liao, Wei-Wu, 310 Hsinchu County (TW)
(74) Representative: Straus, Alexander

(56) References cited:
- EP-A1- 3 018 657
- EP-A2- 1 890 295
- US-A1- 2008 117 660
- US-B1- 9 330 794

## Description

### Field of the Invention

The present invention relates to a memory system, and more particularly, the memory system with small size antifuse circuit having a capability of boosting voltage.

### Background of the Invention

Non-volatile memory is a type of memory that retains information it stores even when no power is supplied to memory blocks. Some examples include magnetic devices, optical discs, flash memory, and other semiconductor-based memory topologies.

Non-volatile memory can be categorized in electrically addressed systems (i.e., read-only memory) and mechanically addressed systems (i.e., hard disks, optical disc, magnetic tape, holographic memory, and such). Specifically, since non-volatile memory does not require its memory data to be periodically refreshed, it is commonly used for secondary storage or long-term consistent storage.

Generally, with advancement of techniques, a high density or high capacity-based non-volatile memory is required to facilitate big data accessibility. Thus, a voltage circuit with large size for driving the memory to operate in programing state or in reading state is essential. Even, when the memory is an antifuse-based memory which can be programmed by using a ruptured process (i.e., for example, an antifuse transistor of a memory cell is ruptured and behaves as a MOS capacitor), an antifuse circuit with large size for driving the antifuse-based memory is also required. As a result, since the constraint of circuit size, the voltage circuit and/or the antifuse circuit cannot be placed to the optimal locations on the chip, leading to reduce flexibility or performance of design.

The prior art provides some conventional antifuse circuits. For example, EP1 890295A2 discloses a semiconductor memory device that enables the reduction of the circuit scale of the antifuse write voltage generation circuit, US9330794 discloses apparatuses and methods for programming and reading from anti-fuse cells, EP3018657 discloses a memory cell including a programming selection transistor, a following gate transistor, an antifuse element, and a reading circuit, and US20080117660 discloses a one-time programmable memory device having an array of memory cells, where the cells include an anti-fuse element and an in-cell amplifier transistor. However, these conventional antifuse circuits still fail to illustrate a memory system with small size antifuse voltage generator having a capability of boosting voltage in conjunction with memory cell.

### Summary of the Invention

The present invention aims at providing a memory system having an antifuse voltage generator with low hardware complexity. The antifuse voltage generator can be placed to an optimal location on a chip of memory, leading to improve operation performance and flexibility of design.

This is achieved by a memory system according to the claims here below. The dependent claims pertain to corresponding further developments and improvements.

As will be seen more clearly from the detailed description following below, the claimed memory system comprises a control block, an antifuse voltage generator, an array voltage generator, and a memory array. The control block comprises an input terminal configured to receive a memory control data signal, a first output terminal configured to output a first control signal, a second output terminal configured to output a second control signal, a third output terminal configured to output a third control signal, and a fourth output signal configured to output a fourth control signal. The antifuse voltage generator comprises a first input terminal coupled to the second output terminal of the control block and configured to receive the second control signal, a second input terminal configured to receive a driving voltage, and an output terminal configured to output an antifuse control signal. The array voltage generator comprises a first input terminal coupled to the third output terminal of the control block and configured to receive the third control signal, a second input terminal configured to receive the driving voltage, a first output terminal configured to output a selection signal, and a second output terminal configured to output a following control signal. The memory array is coupled to the control block, the antifuse voltage generator, and the array voltage generator and configured to access data according to the first control signal, the antifuse control signal, the selection signal, and the following control signal. The first control signal comprises address information of the memory array.

The memory system according to the present invention uses an antifuse voltage generator with small circuit size and low complexity to accomplish voltage boost process for driving a memory array. Since the antifuse voltage generator is implemented by using several simple circuits, the antifuse voltage generator can be placed to an optimal location on a chip of memory in order to enhance layout efficiency and design flexibility, especially in the memory system with high density.

### Brief Description of the Drawings

In the following, the invention is further illustrated by way of example, taking reference to the accompanying drawings. Thereof
FIG.1 illustrates a block diagram of a memory system according to an embodiment of the present invention;
FIG.2 illustrates a structure of a memory cell of a memory system in FIG.1;
FIG.3 illustrates a schematic diagram of memory cell allocation on a memory array of the memory system in FIG.1;
FIG.4 illustrates a structure of an antifuse voltage generator of the memory system in FIG.1;
FIG.5 illustrates a schematic diagram of the antifuse voltage generator in FIG.4 during a reading operation;
FIG.6 illustrates a schematic diagram of the antifuse voltage generator in FIG.4 during a programming operation;
FIG.7 illustrates a schematic diagram of cross voltages of transistors of the antifuse voltage generator in FIG.6 at a pull-low gate signal;
FIG.8 illustrates a schematic diagram of cross voltages of transistors of the antifuse voltage generator in FIG.6 at a pull-high gate signal;
FIG.9 illustrates another structure of an antifuse voltage generator of the memory system in FIG.1 during a programming operation;
FIG.10 illustrates a schematic diagram of cross voltages of transistors of the antifuse voltage generator in FIG.9 at a pull-low gate signal;
FIG.11 illustrates a schematic diagram of cross voltages of transistors of the antifuse voltage generator in FIG.9 at a pull-high gate signal; and
FIG.12 illustrates a block diagram of a memory system according to another embodiment of the present invention.

### Detailed Description

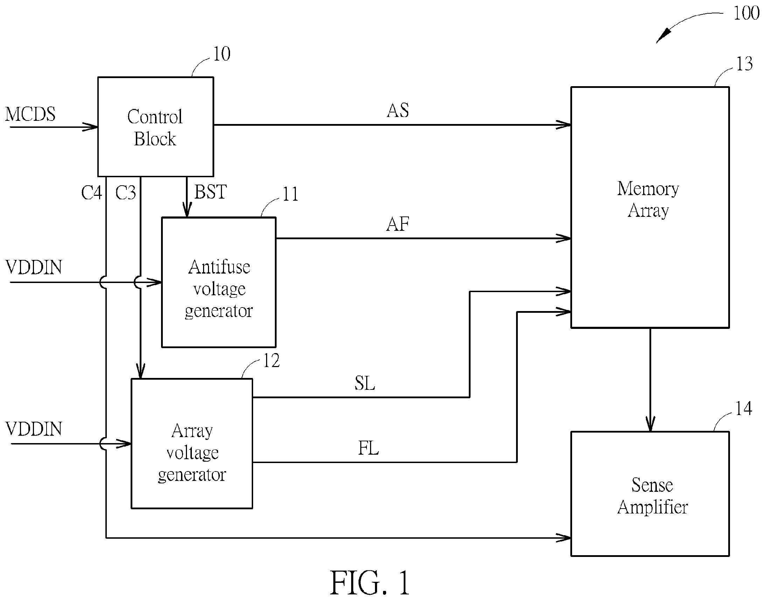

FIG.1 illustrates a block diagram of a memory system 100 according to an embodiment of the present invention. The memory system 100 includes a control block 10, an antifuse voltage generator 11, an array voltage generator 12, a memory array 13, and a sense amplifier 14. The control block includes an input terminal, a first output terminal, a second output terminal, a third output terminal, and a fourth output terminal. The input terminal is used for receiving a memory control data signal MCDS.

Specifically, the memory control data signal MCDS can be an external data signal bearing all information of the memory system 100, such as address information of the memory array 13, all configurations information, driving information, and operation modes information. The memory control data signal MCDS can also be a user-defined data signal. The first output terminal is used for outputting a first control signal AS. The first control signal AS can carry address information of the memory array 13 so that specific memory cells located on specific addresses of the memory array 13 can be enabled accordingly. The second output terminal is used for outputting a second control signal BST. The third output terminal is used for outputting a third control signal C3. The fourth output signal is used for outputting a fourth control signal C4. The antifuse voltage generator 11 includes a first input terminal, a second input terminal, and an output terminal. The first input terminal is coupled to the second output terminal of the control block 10 for receiving the second control signal BST. The second input terminal is used for receiving a driving voltage VDDIN. The output terminal is used for outputting an antifuse control signal AF. The array voltage generator 12 includes a first input terminal, a second input terminal, a first output terminal, and a second output terminal. The first input terminal is coupled to the third output terminal of the control block 10 for receiving the third control signal C3. The second input terminal is used for receiving the driving voltage VDDIN. The first output terminal is used for outputting a selection signal SL. The second output terminal is used for outputting a following control signal FL. The memory array 13 is coupled to the control block 10, the antifuse voltage generator 11, and the array voltage generator 12 for accessing data according to the first control signal AS, the antifuse control signal AF, the selection signal SL, and the following control signal FL.

Particularly, the memory array 13 can be a non-volatile memory cell array. The memory array 13 includes a plurality of memory cells. Each memory cell can perform reading operation and programming operation. Further, the sense amplifier 14 is coupled to the fourth terminal of the control block 10 and the memory array 13 for detecting and comparing a bit line current of the memory array 13 with a reference current. In the following, a structure of the memory cell and a method for driving the memory cell during reading operation and programming operation are described.

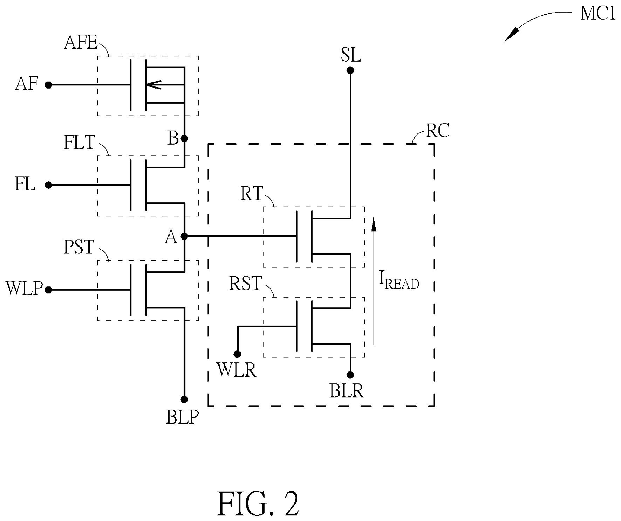

FIG.2 illustrates a structure of a memory cell MC1 of the memory system 100. The memory cell MC1 can be four transistors and one varactor-based (4T1V) memory cell. Specifically, the memory cell MC1 includes a programming selection transistor PST, a following gate transistor FLT, an antifuse element AFE, and a reading circuit RC. The programming selection transistor PST includes a first terminal, a second terminal, and a control terminal. The second terminal is used for receiving a bit line program signal BLP. The control terminal is used for receiving a word line program signal WLP. The following gate transistor FLT includes a first terminal, a second terminal, and a control terminal. The second terminal is coupled to the first terminal of the programming selection transistor PST. The control terminal is used for receiving the following control signal FL. The antifuse element AFE includes a first terminal and a second terminal. The first terminal is used for receiving the antifuse control signal AF. The second terminal is coupled to the first terminal of the following gate transistor FLT. The reading circuit RC is coupled to the second terminal of the following gate transistor FLT for forming a read current I_{READ} according to a bit line read signal BLR, a word line read signal WLR, and the selection signal SL during a reading operation of the memory cell MC1. Here, the antifuse element AFE can be a varactor. The following gate transistor FLT can be implemented by a native device, a short channel device or a varactor. Specifically, the reading circuit RC can be regard as an auxiliary circuit in order to improve driving performance during the reading operation of the memory cell MC1. The operation of the reading circuit RC is illustrated later. In the memory cell MC1, the reading circuit RC includes a reading transistor RT and a read selection transistor RST. The reading transistor includes a first terminal, a second terminal, and a control terminal. The first terminal is used for receiving the selection signal SL. The control terminal is coupled to the second terminal of the following gate transistor FLT. The read selection transistor RST includes a first terminal, a second terminal, and a control terminal. The first terminal is coupled to the second terminal of the reading transistor RT. The second terminal is used for receiving the bit line read signal BLR. The control terminal is used for receiving the word line read signal WLR. In the memory cell MC1, the programming selection transistor PST, the following gate transistor FLT, the reading transistor RT, and the read selection transistor RST can be N-type metal-oxide-semiconductor field-effect transistors. The operations of the memory cell MC1 is illustrated below.

When the memory cell MC1 is operated in a reading mode, the bit line program signal BLP is at a second voltage equal to 0 volt. The word line program signal WLP changes from a first voltage VDD to the second voltage (0V). Here, the first voltage VDD can be a predetermined circuit voltage greater than 0 volt (i.e., for example, the first voltage VDD can be 1 volt) . The following control signal FL is at the first voltage VDD. The antifuse control signal AF is at the first voltage VDD. The bit line read signal BLR is at the first voltage VDD. The selection signal SL is at the second voltage (0V). The word line read signal WLR is at the first voltage VDD. Table A illustrates all signal statuses of the memory cell MC1 during the reading operation, as shown below.

**Table A**

| Mode | AF | FL | WLP | BLP | WLR | SL | BLR |
|---|---|---|---|---|---|---|---|
| Read | VDD | VDD | VDD to 0V | 0V | VDD | 0V | VDD |

By doing so, the programming selection transistor PST is enabled and then disabled since the control terminal receives the word line program signal WLP from the first voltage VDD to 0V. Thus, an initial voltage of a node A is equal to 0V. The following gate transistor FLT is enabled since the control terminal receives the following control signal FL with the first voltage VDD. The read selection transistor RST is enabled since the control terminal receives the word line read signal WLR with the first voltage VDD. For presentation completeness, a reading mode with logic "0" and a reading mode with logic "1" are further illustrated as below.

When the memory cell MC1 is operated in the reading mode with logic "0", the antifuse element AFE is operated in a ruptured state and can be regarded as a resistor capable of conduction. Thus, the voltage of the node A is increased from a grounded voltage (0V) to (VDD-Vx) wherein Vx is a small offset voltage since the following gate transistor FLT is enabled. Once the voltage of the node A becomes (VDD-Vx), the reading transistor RT is also enabled since the control terminal receives a high voltage equal to (VDD-Vx). As a result, since the reading transistor RT and the read selection transistor RST are enabled, the read current I_{READ} can be generated from a terminal of the bit line read signal BLR to a terminal of the selection signal SL.

When the memory cell MC1 is operated in the reading mode with logic "1", the antifuse element AFE is operated in a non-ruptured state and can be regarded as an insulator. Thus, the voltage of the node A is maintained around the grounded voltage (0V). Since the voltage of the node A is substantially equal to the grounded voltage (0V), the reading transistor RT is disabled. As a result, since the reading transistor RT is disabled, no read current I_{READ} is introduced from the terminal of the bit line read signal BLR to the terminal of the selection signal SL.

Briefly, when the memory cell MC1 is operated in the reading mode with logic "0", the antifuse element AFE is operated in the ruptured state. Thus, the read current I_{READ} is generated. When the memory cell MC1 is operated in the reading mode with logic "1", the antifuse element AFE is operated in the non-ruptured state. Thus, no read current I_{READ} is generated.

Further, a programming mode with logic "0" and a programming mode with logic "1" are illustrated as below. When the memory cell MC1 is operated in a programming mode with logic "0", the bit line program signal BLP is at a second voltage equal to 0 volt. The word line program signal WLP is at a first voltage VDD. Here, the first voltage VDD can be a predetermined circuit voltage greater than 0 volt (i.e., for example, the first voltage VDD can be 1 volt) . The following control signal FL is at a voltage level between the first voltage VDD and a third voltage VPP. For example, the following control signal FL can be at half of the third voltage VPP. Here, the third voltage VPP is greater than the first voltage VDD. For example, the third voltage VPP can be 7 volts. The antifuse control signal AF is at the third voltage VPP. The bit line read signal BLR is at the first voltage VDD. The selection signal SL is at the first voltage VDD. The word line read signal WLR is at the first voltage VDD. By doing so, the programming selection transistor PST is enabled since the control terminal receives the word line program signal with the first voltage VDD (i.e., the cross voltage Vgs between the control terminal and the second terminal is substantially equal to the first voltage VDD). Since the programming selection transistor PST is enabled, a voltage of a node A is equal to 0 volt (i.e., bit line program signal BLP is equal to 0 volt). Here, the following gate transistor FLT is enabled since the control terminal receives the following control signal FL with the voltage VPP/2 greater than first voltage VDD. Thus, since the following gate transistor FLT is enabled, a voltage of a node B is equal to the voltage of the node A at 0 volt (i.e., node A and node B become two grounded terminals equivalently). As a result, a cross voltage between a first terminal and a second terminal of the antifuse element AFE is substantially equal to the third voltage VPP. A circuit loop for rupturing the antifuse element AFE exists. For example, when the third voltage VPP is designed as 7 volts, the cross voltage of the antifuse element AFE is high enough for triggering a rupture process of the antifuse element AFE.

When the memory cell MC1 is operated in a programming mode with logic "1", voltages of the antifuse control signal AF, the following control signal FL, the word line program signal WLP, the bit line read signal BLR, the word line read signal WLR, and the selection signal SL are similar to the programming mode with logic "0". The difference is that the bit line program signal BLP is at the first voltage VDD. By doing so, the programming selection transistor PST may be disabled since the cross voltage between a source and a drain terminals is too small. As a result, a circuit loop for rupturing the antifuse element AFE does not exist. No rupture process of the antifuse element AFE is triggered.

Table B illustrates all signal statuses of the memory cell MC1 during the programming operation, as shown below.

**Table B**

| Mode | AF | FL | WLP | BLP | WLR | SL | BLR |
|---|---|---|---|---|---|---|---|
| Program | VPP | VPP/2 | VDD | 0V (logic "0") | VDD | VDD | VDD |
| | | | | VDD (logic "1") | | | |

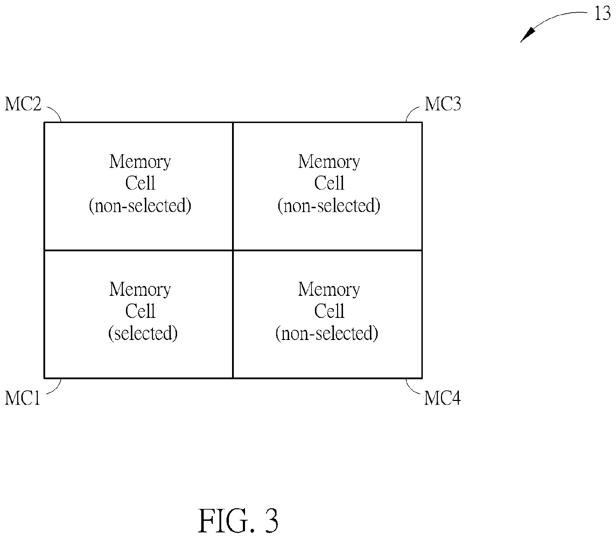

As aforementioned structure, the memory array 13 includes a plurality of memory cells. For example, the memory array 13 can include N×M memory cells, wherein N and M are two positive integers. For presentation simplicity, four memory cells are introduced to the memory array 13. FIG.3 illustrates a schematic diagram of memory cell allocation on the memory array 13. Here, the memory array 13 includes a memory cell MC1, a memory cell MC2, a memory cell MC3, and a memory cell MC4. All memory cells have a same circuit structure illustrated in FIG.2. Specifically, according to the first control signal AS bearing address information, the memory cell MC1 is selected for driving the reading operation or the programming operation. The memory cell MC2, the memory cell MC3, and the memory cell MC4 can regarded as non-selected memory cells. In other words, when the memory cell MC1 is operated in reading mode, the memory cell MC2, the memory cell MC3, and the memory cell MC4 are operated in reading inhibit mode. When the memory cell MC1 is operated in programming mode, the memory cell MC2, the memory cell MC3, and the memory cell MC4 are operated in programming inhibit mode. For presentation completeness, when the memory cell MC1 is driven, all signals of the memory cell MC1 to the memory cell MC4 are listed in Table C and Table D. Here, Table C illustrated signal statuses of the memory array 13 when the memory cell MC1 is operated under reading mode, while the memory cells MC2 to MC4 are operated under the reading inhibit mode.

**Table C**

| Mode | AF | FL | WLP | BLP | WLR | SL | BLR |
|---|---|---|---|---|---|---|---|
| MC1 (reading) | VDD | VDD | VDD to 0V | 0V | VDD | 0V | VDD |
| MC2 (reading inhibit) | VDD | VDD | 0V | 0V | 0V | 0V | VDD |
| MC3 (reading inhibit) | VDD | VDD | 0V | 0V | 0V | 0V | 0V |
| MC4 (reading inhibit) | VDD | VDD | VDD to 0V | 0V | VDD | 0V | 0V |

Further, Table D illustrated signal statuses of the memory array 13 when the memory cell MC1 is operated under programming mode, while the memory cells MC2 to MC4 are operated under the programming inhibit mode.

**Table D**

| Mode | AF | FL | WLP | BLP | WLR | SL | BLR |
|---|---|---|---|---|---|---|---|
| MC1 (programming) | VPP | VPP/2 | VDD | 0V (logic "0") | VDD | VDD | VDD |
| | | | | VDD (logic "1") | | | |
| MC2 (programming inhibit) | VPP | VPP/2 | 0V | 0V | 0V | VDD | VDD |
| MC3 (programming inhibit) | VPP | VPP/2 | 0V | VDD | 0V | VDD | VDD |
| MC4 (programming inhibit) | VPP | VPP/2 | VDD | VDD | VDD | VDD | VDD |

In the memory system 100, since two operation modes (i.e., the reading mode and the programming mode) are introduced, an appropriate antifuse voltage generator 11 is required for outputting a corresponding antifuse control signal AF. For example, when the memory cell MC1 is enabled during reading operation, the antifuse control signal AF is at a voltage level equal to the first voltage VDD (i.e., 1 volt). When the memory cell MC1 is enabled during programming operation, the antifuse control signal AF is at a voltage level equal to the third voltage VPP (i.e., 7 volts). In the following, a structure of the antifuse voltage generator is described.

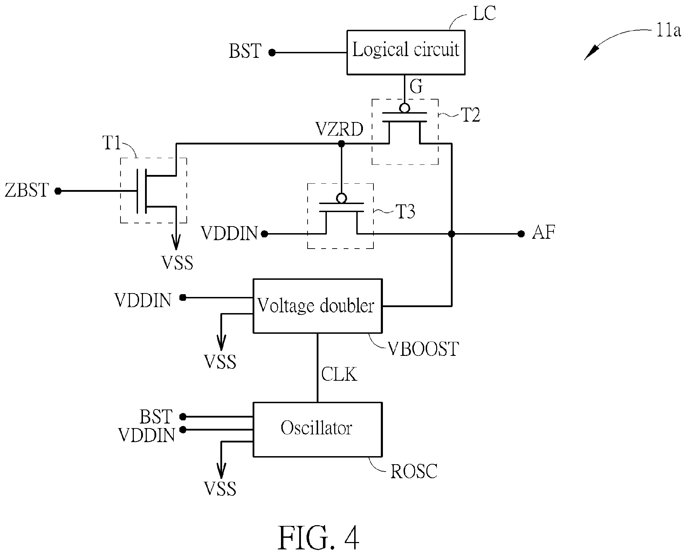

FIG.4 illustrates a structure of the antifuse voltage generator 11a. The antifuse voltage generator 11a can be applied to the antifuse voltage generator 11 of the memory system 100. The antifuse voltage generator 11a includes an oscillator ROSC, a voltage doubler VBOOST, a first transistor T1, a second transistor T2, and a third transistor T3. The oscillator ROSC includes a first input terminal, a second input terminal, a third input terminal, and an output terminal. The first input terminal is used for receiving the second control signal BST. The second input terminal is used for receiving the driving voltage VDDIN. The third input terminal is used for receiving a second voltage VSS. The output terminal is used for outputting a clock signal CLK. Here, the oscillator ROSC can be any typed oscillator, such as a ring oscillator. The voltage doubler VBOOST includes a first input terminal, a second input terminal, a third input terminal, and an output terminal. The first input terminal is used for receiving the driving voltage VDDIN. The second input terminal is used for receiving the second voltage VSS. The third input terminal is coupled to the output terminal of the oscillator ROSC for receiving the clock signal CLK. The output terminal is used for outputting the antifuse control signal AF during a programming operation. The first transistor T1 includes a first terminal, a second terminal, and a control terminal. The first terminal is used for receiving the second voltage VSS. The control terminal is used for receiving an inverse signal ZBST of the second control signal BST. The second transistor T2 includes a first terminal, a second terminal, and a control terminal. The first terminal is coupled to the second terminal of the first transistor T1. The second terminal is coupled to the output terminal of the voltage doubler VBOOST. The control terminal is used for receiving a gate signal G through a logical circuit LC according to the second control signal BST. The logical circuit LC can be a delay logical circuit. The third transistor T3 includes a first terminal, a second terminal, and a control signal. The first terminal is used for receiving the driving voltage VDDIN. The second terminal is coupled to the second terminal of the second transistor T2 for outputting the antifuse control signal AF during a reading operation. The control signal is coupled to the first terminal of the second transistor T2. In the antifuse voltage generator 11a, the driving voltage VDDIN is higher than the second voltage VSS. For example, the driving voltage VDDIN can be equal to 1 volt or 3.5 volts. The second voltage VSS can be a grounded voltage equal to 0 volt. The first transistor T1 can be an N-type metal-oxide-semiconductor field-effect transistor. The second transistor T2 and the third transistor T3 can be P-type metal-oxide-semiconductor field-effect transistors. The driving modes of the antifuse voltage generator 11a during the reading operation and the programming operation of the memory array 13 are illustrated below.

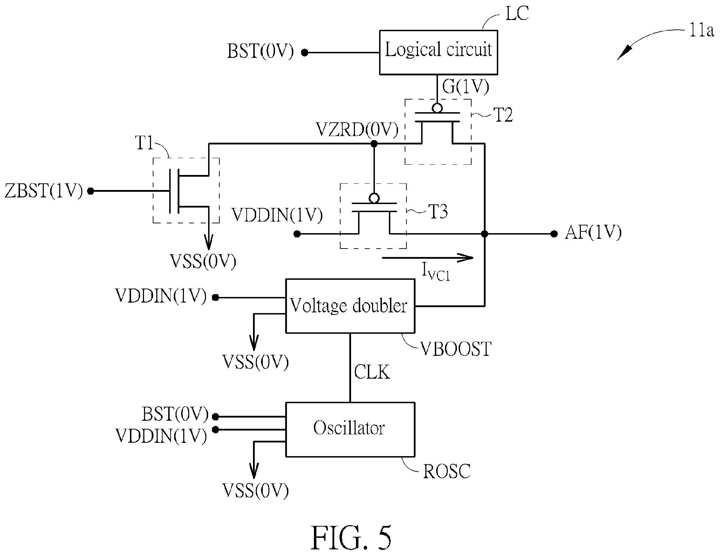

FIG.5 illustrates a schematic diagram of the antifuse voltage generator 11a during a reading operation. Here, the second voltage VSS is equal to a grounded voltage (0 volt) . The second control signal BST is equal to the grounded voltage (0 volt). The inverse signal ZBST of the second control signal BST is equal to a first voltage VDD (1 volt). The gate signal G is equal to the driving voltage VDDIN (1 volt). The antifuse control signal AF is equal to the driving voltage (1 volt). All signal statuses of the antifuse voltage generator 11a during the reading operation can be listed in Table E.

**Table E**

| Mode | VDDIN | VSS | AF | BST | ZBST | G |
|---|---|---|---|---|---|---|
| Reading | 1V | 0V | 1V | 0V | 1V (VDD) | 1V(VDDIN) |

The operation mode of the antifuse voltage generator 11a can be illustrated below. During the reading operation, since the voltage doubler VBOOST receives the driving voltage VDDIN equal to 1 volt, the clock signal CLK is fixed at a level equal to 0 volt or 1 volt, the voltage doubler VBOOST is disabled and can be regarded as a void device. Thus, the output terminal of the voltage doubler VBOOST becomes a floating terminal. Further, since the control terminal of the first transistor T1 receives the inverse signal ZBST of the second control signal BST equal to 1 volt, the first transistor T1 is enabled. Thus, a voltage of a node VZRD is equal to 0 volt (the second voltage VSS). Since the control terminal of the second transistor T2 receives the gate signal G equal to 1 volt, the second transistor T2 is disabled. Specifically, since the control terminal of the third transistor T3 receives the voltage of the node VZRD equal to 0 volt, the third transistor T3 is enabled. As a result, a voltage of the antifuse control signal AF is equal to the driving voltage VDDIN (1V) received by the first terminal of the third transistor T3 since a current I_{VC1} can be formed from the first terminal to the second terminal of the third transistor T3. By doing so, since the antifuse control signal AF with 1 volt can be outputted from the antifuse voltage generator 11a during the reading operation (or say, a time interval of reading operation), the memory array 13 can be operated correctly.

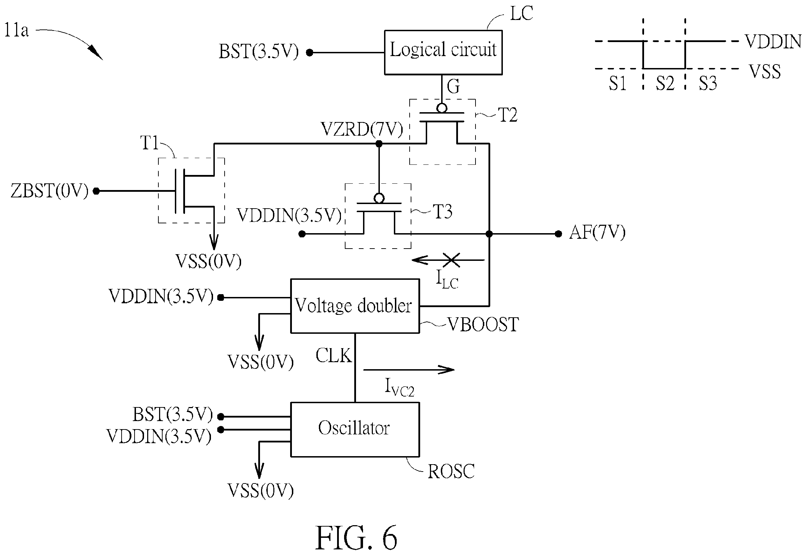

FIG.6 illustrates a schematic diagram of the antifuse voltage generator 11a during a programming operation. Here, the second voltage VSS is equal to a grounded voltage (0 volt) . The second control signal BST is equal to 3.5 volts. The inverse signal ZBST of the second control signal BST is equal to the grounded voltage (0 volt) . The gate signal G is changed from the driving voltage VDDIN (3.5 volts) to the grounded voltage (0 volt). The gate signal G can be further changed from the grounded voltage (0 volt) to the driving voltage VDDIN (3.5 volt) after the gate signal G is changed from the driving voltage VDDIN (3.5 volt) to the grounded voltage (0 volt) . The antifuse control signal AF is equal to two times of the driving voltage VDDIN (i.e., 7 volts). All signal statuses of the antifuse voltage generator 11a during the programming operation can be listed in Table F.

**Table F**

| Mode | VDDIN | VSS | AF | BST | ZBST | G |
|---|---|---|---|---|---|---|
| Programming | 3.5V | 0V | 7V | 3.5V(VDDIN) | 0V | VDDIN to 0V to VDDIN |

In other words, for the antifuse voltage generator 11a during a programming operation, the gate signal G follows three states. In an initial state, a voltage of the gate signal G is equal to the driving voltage VDDIN (3.5 volt) during a time interval S1. In an operation state, the voltage of the gate signal G is equal to the second voltage VSS (0 volt) during a time interval S2. In a final state, the voltage of the gate signal G is equal to the driving voltage VDDIN (3.5 volt) during a time interval S3. When the antifuse voltage generator 11a is operated from the reading operation to the programming operation, the voltage of the gate signal G is changed from the initial state to the operation state. Specifically, when the voltage of the gate signal G is equal to the second voltage VSS (0 volt), the operation mode of the antifuse voltage generator 11a can be illustrated below. Since the voltage doubler VBOOST receives the driving voltage VDDIN equal to 3.5 volt, the clock signal CLK toggles between 3.5 volt and 0 volt. Thus, the voltage doubler VBOOST is enabled and can generate the antifuse control signal AF equal to two times of the driving voltage VDDIN (7 volts) according to the clock signal CLK generated from the oscillator ROSC. Here, since the control terminal of the first transistor T1 receives the inverse signal ZBST of the second control signal BST equal to 0 volt, the first transistor T1 is disabled. Since the control terminal of the second transistor T2 receives the gate signal G equal to 0 volt, the second transistor T2 is enabled. Thus, a voltage of a node VZRD is equal to 7 volts (i.e., voltage of the antifuse control signal AF). Further, since the control terminal of the third transistor T3 receives the voltage of the node VZRD equal to 7 volts, the third transistor T3 is disabled. As a result, since the third transistor T3 is disabled, a leakage current I_{LC} from the second terminal (7 volt) to the first terminal (3.5 volts) of the third transistor T3 is disappeared. By doing so, since the antifuse control signal AF with 7 volts can be outputted from the antifuse voltage generator 11a during the programming operation (or say, a time interval of programming operation), the memory array 13 can be operated correctly.

Briefly, when the antifuse voltage generator 11a is enabled during a reading operation, the antifuse control signal AF is outputted with the voltage level equal to 1 volt according to the current I_{VC1} generated from the third transistor T3. When the antifuse voltage generator 11a is enabled during a programming operation, the antifuse control signal AF is outputted with the voltage level equal to 7 volts according to a current I_{VC2} generated from the voltage doubler VBOOST. In FIG. 6, the antifuse voltage generator 11a can output the antifuse control signal AF with the voltage level equal to 7 volts during a time interval S2. Then, the gate signal G can remain to a signal with a voltage level equal to 0 volt. The gate signal G can also be changed as a signal with a voltage level equal to 3.5 volts during a time interval S3. In the following, effects of the transistors of the antifuse voltage generator 11a for different final states of the gate signal G are illustrated.

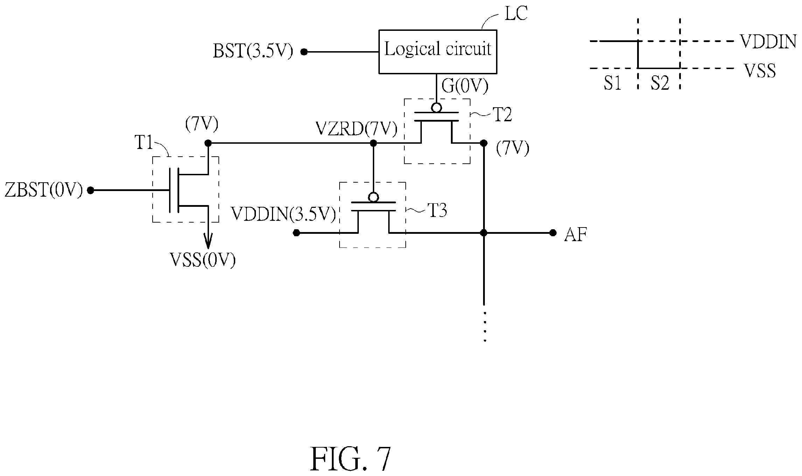

FIG.7 illustrates a schematic diagram of cross voltages of transistors T1 to T3 of the antifuse voltage generator 11a at a pull-low gate signal G. Here, the pull-low gate signal G is defined as a gate signal during a time interval S2. As aforementioned operation in FIG.6, the first transistor T1 is disabled. The second transistor T2 is enabled. The third transistor T3 is disabled. As a result, a cross voltage between the first terminal and the control terminal of the first transistor T1 is equal to 0 volt. A cross voltage between the second terminal and the control terminal of the first transistor T1 is equal to 7 volts. Thus, the first transistor T1 suffers high cross voltage effect, leading to reduce lifetime. A cross voltage between the first terminal and the control terminal of the second transistor T2 is equal to 7 volts. A cross voltage between the second terminal and the control terminal of the second transistor T2 is equal to 7 volts. Thus, the second transistor T2 suffers high cross voltage effect, leading to reduce lifetime. A cross voltage between the first terminal and the control terminal of the third transistor T3 is equal to 3.5 volts. A cross voltage between the second terminal and the control terminal of the third transistor T3 is equal to 0 volts. Thus, no high cross voltage effect is introduced to the third transistor T3. As a result, when the gate signal G becomes the pull-low gate signal and remains a pull-low status, high cross voltage effect is introduced to the first transistor T1 and the second transistor T2. In other words, although the operations of the antifuse voltage generator 11a in FIG.7 can provide the voltage level (7 volts) of the antifuse control signal AF during programming operation, lifetimes of the first transistor T1 and the second transistor T2 may be reduced due to the high cross voltage effect.

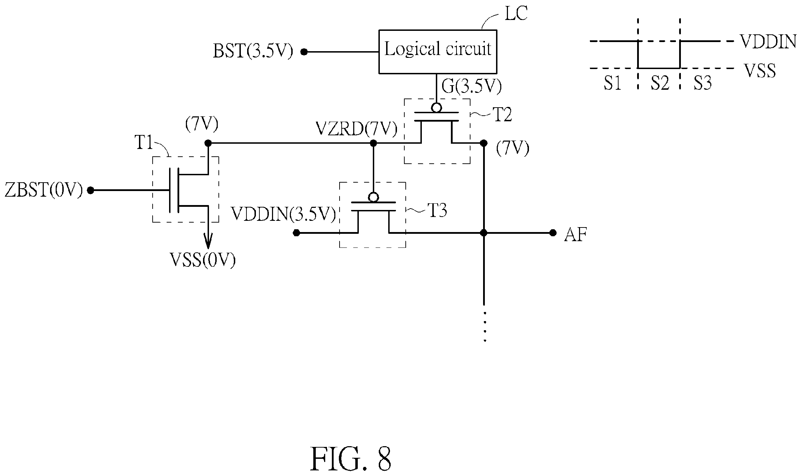

FIG.8 illustrates a schematic diagram of cross voltages of transistors T1 to T3 of the antifuse voltage generator 11a at a pull-high gate signal G. Here, the pull-high gate signal G is defined as a gate signal during a time interval S3. Here, the first transistor T1 is disabled since the control terminal receives the inverse signal ZBST of the second control signal BST equal to 0 volt. Thus, a cross voltage between the first terminal and the control terminal of the first transistor T1 is equal to 0 volt. A cross voltage between the second terminal and the control terminal of the first transistor T1 is equal to 7 volts (i.e., a transient voltage of the second terminal is equal to 7 volts). Thus, the first transistor T1 suffers high cross voltage effect, leading to reduce lifetime. A cross voltage between the first terminal and the control terminal of the second transistor T2 is equal to 3.5 volts. A cross voltage between the second terminal and the control terminal of the second transistor T2 is equal to 3.5 volts. Thus, no high cross voltage effect is introduced to the second transistor T2. A cross voltage between the first terminal and the control terminal of the third transistor T3 is equal to 3.5 volts. A cross voltage between the second terminal and the control terminal of the third transistor T3 is equal to 0 volts. Thus, no high cross voltage effect is introduced to the third transistor T3. As a result, when the gate signal G becomes the pull-high gate during the time interval S3, high cross voltage effect is introduced to the first transistor T1. In other words, although the operations of the antifuse voltage generator 11a in FIG.7 can provide the voltage level (7 volts) of the antifuse control signal AF during programming operation, lifetimes of the first transistor T1 may be reduced due to the high cross voltage effect. Comparing with the operations in FIG.7 and FIG.8, at least one transistor with high cross voltage still exists. By avoiding high cross voltage effect, another antifuse voltage generator is introduced and illustrated as below.

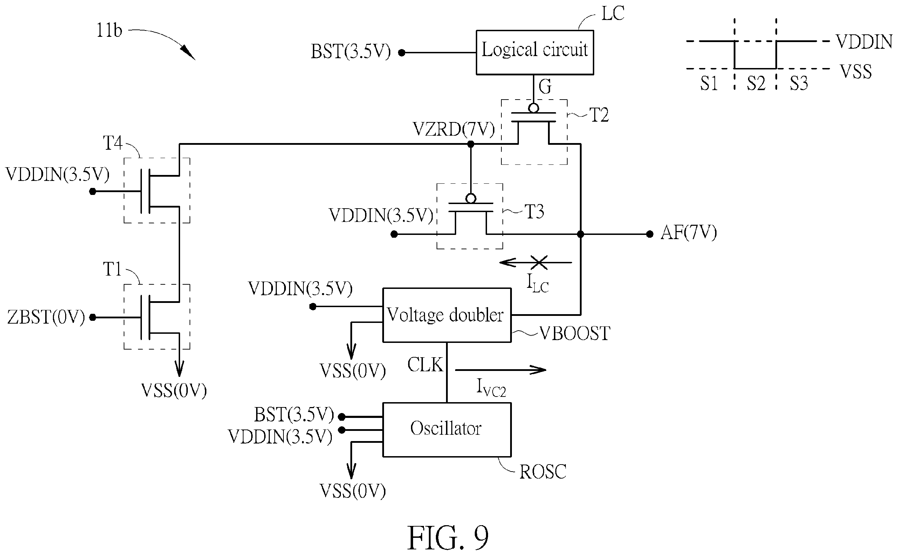

FIG.9 illustrates another structure of an antifuse voltage generator 11b during a programming operation. The antifuse voltage generator 11b can be applied to the antifuse voltage generator 11 of the memory system 100. Specifically, a structure of the antifuse voltage generator 11b is similar to the structure of the antifuse voltage generator 11a. The difference is that an additional transistor T4 (i.e., hereafter, say "a fourth transistor T4") is introduced to the antifuse voltage generator 11b. Since an oscillator ROSC, a voltage doubler VBOOST, a first transistor T1, a second transistor T2, and a third transistor T3 of the antifuse voltage generator 11b are similar to the antifuse voltage generator 11a, illustrations of these components are omitted here. In the antifuse voltage generator 11b, the fourth transistor T4 includes a first terminal, a second terminal, and a control terminal. The first terminal is coupled to a second terminal of the first transistor T1. The second terminal is coupled to a first terminal of the second transistor T2. The control terminal is used for receiving the driving voltage VDDIN (3.5 volts). The fourth transistor T4 can be an N-type metal-oxide-semiconductor field-effect transistor. Specifically, the fourth transistor T4 is enabled since the control terminal receives the driving voltage VDDIN equal to 3.5 volts. Thus, since the fourth transistor T4 of the antifuse voltage generator 11b is always enabled during reading operation (i.e., VDDIN in equal to 1 volt) and during programming operation (i.e., VDDIN in equal to 3.5 volts), the driving methods for generating a corresponding antifuse control signal AF during reading operation and the programming operation are similar to the driving methods of the antifuse voltage generator 11a. Thus, these illustrations are also omitted here. In FIG.9, similarly, the antifuse voltage generator 11b can output the antifuse control signal AF with the voltage level equal to 7 volts during a time interval S2. Then, the gate signal G can remain to a signal with a voltage level equal to 0 volt. The gate signal G can also be changed as a signal with a voltage level equal to 3.5 volts (VDDIN) during a time interval S3. In the following, effects of the transistors of the antifuse voltage generator 11b for different final states of the gate signal G are illustrated.

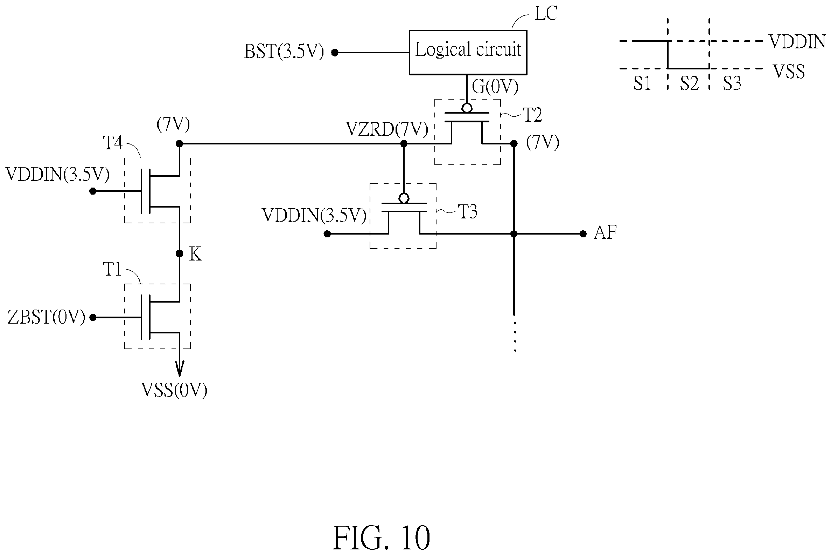

FIG.10 illustrates a schematic diagram of cross voltages of transistors T1 to T4 of the antifuse voltage generator 11b at a pull-low gate signal G. Here, the pull-low gate signal G is defined as a gate signal during a time interval S2. As aforementioned operation, the first transistor T1 is disabled. The second transistor T2 is enabled. The third transistor T3 is disabled. The fourth transistor T4 is enabled. Note that a node K can be a voltage around (3.5-Vthn) volts, wherein Vthn can be a predetermined threshold voltage of T4. Thus, since no transient current is introduced to the first transistor T1 and the control terminal of the first transistor T1 receives the inverse signal ZBST of the second control signal BST equal to 0 volt, a cross voltage of the first transistor T1 is small. Thus, no high cross voltage effect is introduced to the first transistor T1. A cross voltage between the first terminal and the control terminal of the fourth transistor T4 is equal to Vthn volts. A cross voltage between the second terminal and the control terminal of the fourth transistor T4 is equal to 3.5 volts. Thus, no high cross voltage effect is introduced to the fourth transistor T4. A cross voltage between the first terminal and the control terminal of the second transistor T2 is equal to 7 volts. A cross voltage between the second terminal and the control terminal of the second transistor T2 is equal to 7 volts. Thus, the second transistor T2 suffers high cross voltage effect. A cross voltage between the first terminal and the control terminal of the third transistor T3 is equal to 3.5 volts. A cross voltage between the second terminal and the control terminal of the third transistor T3 is equal to 0 volts. Thus, no high cross voltage effect is introduced to the third transistor T3. As a result, when the gate signal G becomes the pull-low gate signal and remains a pull-low status, high cross voltage effect is introduced to the second transistor T2. In other words, although the operations of the antifuse voltage generator 11b in FIG.10 can provide the voltage level (7 volts) of the antifuse control signal AF during programming operation, lifetimes of the second transistor T2 may be reduced due to the high cross voltage effect, while the high cross voltage effect of the transistor T1 is mitigated.

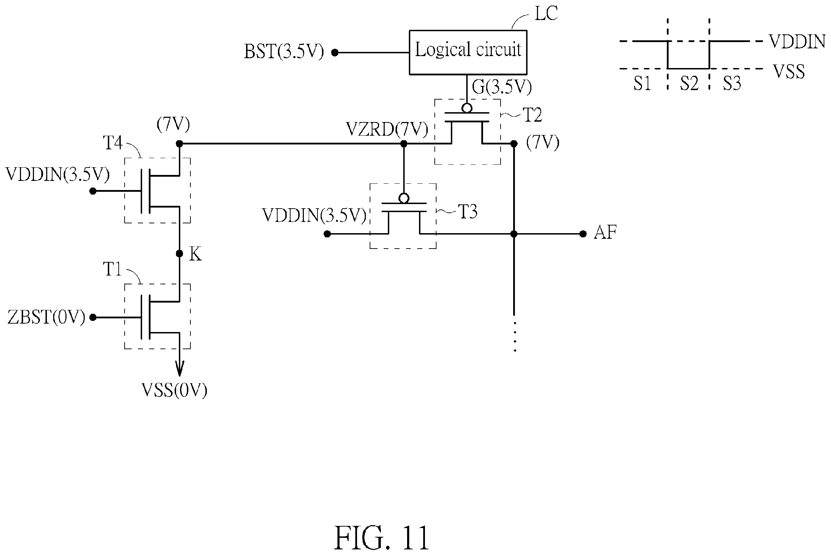

FIG.11 illustrates a schematic diagram of cross voltages of transistors T1 to T4 of the antifuse voltage generator 11b at a pull-high gate signal G. Here, the pull-high gate signal G is defined as a gate signal during a time interval S3. Here, the first transistor T1 is disabled since the control terminal receives the inverse signal ZBST of the second control signal BST equal to 0 volt. Note that the first transistor T1 is disabled and operated under an open-circuit state. As a result, since no transient current is introduced to the first transistor T1 and the control terminal of the first transistor T1 receives the inverse signal ZBST of the second control signal BST equal to 0 volt, a cross voltage of the first transistor T1 is small. Thus, no high cross voltage effect is introduced to the first transistor T1. A cross voltage between the first terminal and the control terminal of the fourth transistor T4 is equal to 3.5 volts. Similar to a status of the fourth transistor T4 in FIG.10, no high cross voltage effect is introduced to the fourth transistor T4 in FIG.11. A cross voltage between the first terminal and the control terminal of the second transistor T2 is equal to 3.5 volts. A cross voltage between the second terminal and the control terminal of the second transistor T2 is equal to 3.5 volts. Thus, no high cross voltage effect is introduced to the second transistor T2. A cross voltage between the first terminal and the control terminal of the third transistor T3 is equal to 3.5 volts. A cross voltage between the second terminal and the control terminal of the third transistor T3 is equal to 0 volts. Thus, no high cross voltage effect is introduced to the third transistor T3. As a result, when the gate signal G becomes the pull-high gate during the time interval S3, no high cross voltage effect is introduced to the antifuse voltage generator 11b. In other words, the operations of the antifuse voltage generator 11b in FIG.11 can provide the voltage level (7 volts) of the antifuse control signal AF during programming operation. All transistors T1 to T4 can also avoid high cross voltage effect. Thus, the lifetime of the antifuse voltage generator 11b can be spanned.

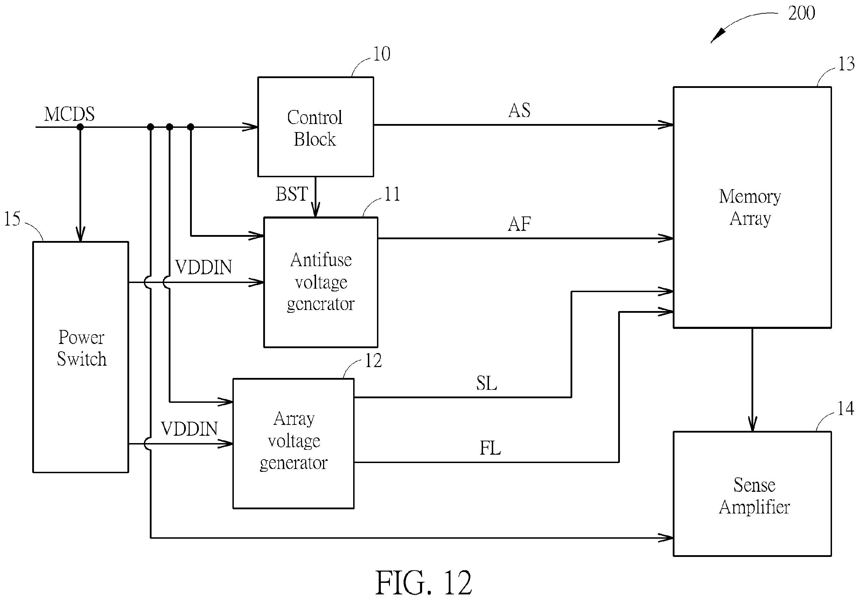

Without loss of generality, another memory system with external power switch is introduced. FIG.12 illustrates a block diagram of a memory system 200 according to another embodiment of the present invention. Particularly, the block diagram of the memory system 200 is similar to the block diagram of the memory system 100. The difference is that a power switch 15 is introduced to the memory system 200. The power switch 15 is coupled to an antifuse voltage generator 11 and an array voltage generator 12. In the memory system 200, the power switch 15 can generate a driving voltage VDDIN to the antifuse voltage generator 11 and the array voltage generator 12. Specifically, control information of the memory control data signal MCDS can be extracted by the power switch 15, the antifuse voltage generator 11, and the array voltage generator 12. For example, information of reading operation of the memory control data signal MCDS can be extracted by the power switch 15, the antifuse voltage generator 11, and the array voltage generator 12. Thus, the power switch 15 can output a driving voltage VDDIN equal to 1 volt. The antifuse voltage generator 11 can output an antifuse control signal AF equal to 1 volt. The array voltage generator 12 can output a following control signal FL equal to 1 volt and a selection signal SL equal to 0 volt. In other words, the power switch 15, the antifuse voltage generator 11, and the array voltage generator 12 can be synchronized to facilitate all operation modes of the memory system 200. Additionally, the power switch 15 can also be an external device controlled by user. The memory control data signal MCDS can also be an external signal defined by user. Consequently, the memory system 200 provides satisfactory flexibility of design.

The preferred embodiment of the application is explicitly detailed in claims 1 and 9 of the accompanying listing of claims.

To sum up, the present invention illustrates a memory system with small size antifuse voltage generator having a capability of boosting voltage in conjunction with memory cell. The antifuse voltage generator includes two sub-circuits coupled in parallel. A first sub-circuit includes a voltage doubler for boosting voltage when the antifuse voltage generator is enabled during programming operation. A second sub-circuit includes several transistors for outputting appropriate voltage when the antifuse voltage generator is enabled during reading operation. Since the antifuse voltage generator is achieved by using several simple circuits with low complexity. The circuit size of the antifuse voltage generator can be also reduced. As a result, since the circuit size of the antifuse voltage generator can be reduced, the antifuse voltage generator can be placed to an optimal location on the chip, leading to improve operation performance and flexibility of design.

## Claims

1. A memory system (100), **characterized by** comprising:
a control block (10) comprising:
an input terminal configured to receive a memory control data signal (MCDS);
a first output terminal configured to output a first control signal (AS);
a second output terminal configured to output a second control signal (BST);
a third output terminal configured to output a third control signal (C3); and
a fourth output terminal configured to output a fourth control signal (C4);
an antifuse voltage generator (11, 11a, 11b) comprising:
a first input terminal coupled to the second output terminal of the control block (10) and configured to receive the second control signal (BST);
a second input terminal configured to receive a driving voltage (VDDIN);
an output terminal configured to output an antifuse control signal (AF);
an oscillator (ROSC) comprising:
a first input terminal configured to receive the second control signal (BST);
a second input terminal configured to receive the driving voltage (VDDIN);
a third input terminal configured to receive a second voltage (VSS); and
an output terminal configured to output a clock signal (CLK);
a voltage doubler (VBOOST) comprising:
a first input terminal configured to receive the driving voltage (VDDIN);
a second input terminal configured to receive the second voltage (VSS);
a third input terminal coupled to the output terminal of the oscillator (ROSC) and configured to receive the clock signal (CLK); and
an output terminal configured to output the antifuse control signal (AF) during a programming operation;
a first transistor (T1) comprising:
a first terminal configured to receive the second voltage (VSS);
a second terminal; and
a control terminal configured to receive an inverse signal (ZBST) of the second control signal (BST);
a second transistor (T2) comprising:
a first terminal coupled to the second terminal of the first transistor (T1);
a second terminal coupled to the output terminal of the voltage doubler (VBOOST); and
a control terminal configured to receive a gate signal (G) through a logical circuit (LC) according to the second control signal (BST); and
a third transistor (T3) comprising:
a first terminal configured to receive the driving voltage (VDDIN);
a second terminal coupled to the second terminal of the second transistor (T2) and configured to output the antifuse control signal (AF) during a reading operation; and
a control terminal coupled to the first terminal of the second transistor (T2);
wherein the driving voltage (VDDIN) is higher than the second voltage (VSS);
an array voltage generator (12) comprising:
a first input terminal coupled to the third output terminal of the control block and configured to receive the third control signal (C3);
a second input terminal configured to receive the driving voltage (VDDIN);
a first output terminal configured to output a selection signal (SL); and
a second output terminal configured to output a following control signal (FL); and
a memory array (13) coupled to the control block (10), the antifuse voltage generator (11, 11a, 11b), and the array voltage generator (12) and configured to access data according to the first control signal (AS), the antifuse control signal (AF), the selection signal (SL), and the following control signal (FL), the memory array (13) comprises a plurality of memory cells (MC1, MC2, MC3, MC4), and each memory cell (MC1) comprises:
a programming selection transistor (PST) comprising:
a first terminal;
a second terminal configured to receive a bit line program signal (BLP); and
a control terminal configured to receive a word line program signal (WLP);
a following gate transistor (FLT) comprising:
a first terminal;
a second terminal coupled to the first terminal of the programming selection transistor (PST); and
a control terminal configured to receive the following control signal (FL);
an antifuse element (AFE) comprising:
a first terminal configured to receive the antifuse control signal (AF); and
a second terminal coupled to the first terminal of the following gate transistor (FLT); and
a reading circuit (RC) coupled to the second terminal of the following gate transistor (FLT) and configured to form a read current (I_{READ}) according to a bit line read signal (BLR), a word line read signal (WLR), and the selection signal (SL) during a reading operation of the memory cell (MC1), the reading circuit (RC) comprising:
a reading transistor (RT) comprising:
a first terminal configured to receive the selection signal (SL);
a second terminal; and
a control terminal coupled to the second terminal of the following gate transistor (FLT); and
a read selection transistor (RST) comprising:
a first terminal coupled to the second terminal of the reading transistor (RT);
a second terminal configured to receive the bit line read signal (BLR); and
a control terminal configured to receive the word line read signal (WLR);
wherein the first control signal (AS) comprises address information of the memory array (13).

2. The memory system (100) of claim 1, further **characterized by** comprising a sense amplifier (14) coupled to the fourth output terminal of the control block (10) and the memory array (13) and configured to detect and compare a bit line current with a reference current.

3. The memory system (100) of claim 1, **characterized in that** the antifuse element (AFE) is a varactor.

4. The memory system (100) of claim 1, **characterized in that** the following gate transistor (FLT) is implemented by a native device, a short channel device or a varactor.

5. The memory system (100) of claim 1, **characterized in that** the first transistor (T1) is an N-type metal-oxide-semiconductor field-effect transistor, and the second transistor (T2) and the third transistor (T3) are P-type metal-oxide-semiconductor field-effect transistors.

6. The memory system (100) of claim 1, **characterized in that** the antifuse voltage generator (11b) further comprises:
a fourth transistor (T4) comprising:
a first terminal coupled to the second terminal of the first transistor (T1);
a second terminal coupled to the first terminal of the second transistor (T2); and
a control terminal configured to receive the driving voltage (VDDIN);
wherein the driving voltage (VDDIN) is greater than the second voltage (VSS).

7. The memory system (100) of either of claims 1 and 6, **characterized in that** the oscillator (ROSC) is a ring oscillator.

8. The memory system (100) of claim 6, **characterized in that** the first transistor (T1) and the fourth transistor (T4) are N-type metal-oxide-semiconductor field-effect transistors, and the second transistor (T2) and the third transistor (T3) are P-type metal-oxide-semiconductor field-effect transistors.

9. A method of operating the memory system (100) of claim 1, **characterized by** during the reading operation of the memory cell (MC1) in the memory array (13), providing the bit line program signal (BLP) at a second voltage (0V) equal to 0 volts, the word line program signal (WLP) at the second voltage (0V), the following control signal (FL) is at a first voltage (VDD), the antifuse control signal (AF) is at the first voltage (VDD), the bit line read signal (BLR) is at the first voltage (VDD), the selection signal (SL) is at the second voltage (0V), the word line read signal (WLR) is at the first voltage (VDD), and the first voltage (VDD) is greater than the second voltage (0V).

10. The method of claim 9, **characterized in that** during a programming operation of logic 1 to the memory cell (MC1) in the memory array (13), providing the bit line program signal (BLP) at the first voltage (VDD), the word line program signal (WLP) is at the first voltage (VDD), the following control signal (FL) is at a voltage level between the first voltage (0V) and a third voltage (VPP), the antifuse control signal (AF) is at the third voltage (VPP), the bit line read (BLR) signal is at the first voltage (VDD), the selection signal (SL) is at the first voltage (VDD), the word line read signal (WLR) is at the first voltage (VDD), and the third voltage (VPP) is greater than the first voltage (VDD).

11. The method of claim 9 or 10, **characterized in that** during a programming operation of logic 0 to the memory cell (MC1) in the memory array (13), by providing the bit line program signal (BLP) at the second voltage (0V), the word line program signal (WLP) is at a the first voltage (VDD), the following control signal (FL) is at a voltage level between the first voltage (VDD) and a third voltage (VPP), the antifuse control signal (AF) is at the third voltage (VPP), the bit line read (BLR) signal is at the first voltage (VDD), the selection signal (SL) is at the first voltage (VDD), the word line read signal (WLR) is at the first voltage (VDD), and the third voltage (VPP) is greater than the first voltage (VDD).

12. The method of claim 9, **characterized by** enabling the antifuse voltage generator (11a) during the reading operation, and when the antifuse voltage generator (11a) is enabled during the reading operation, the second voltage (VSS) is equal to a grounded voltage, the second control signal (BST) is equal to the grounded voltage, the inverse signal (ZBST) of the second control signal (BST) is equal to a fourth voltage (VDD) that is equal to 1 volt, the gate signal (G) is equal to the driving voltage (VDDIN) that is equal to 1 volt, and the antifuse control signal (AF) is equal to the driving voltage (VDDIN).

13. The method of claim 9, **characterized by** enabling the antifuse voltage generator (11a) during the programming operation, and when the antifuse voltage generator (11a) is enabled during the programming operation, the second voltage (VSS) is equal to a grounded voltage, the second control signal (BST) is equal to the driving voltage (VDDIN) that is equal to 3.5 volts, the inverse signal (ZBST) of the second control signal (BST) is equal to a grounded voltage, the gate signal (G) is changed from the grounded voltage to the driving voltage (VDDIN) after the gate signal (G) is changed from the driving voltage (VDDIN) to the grounded voltage, and the antifuse control signal (AF) is equal to two times of the driving voltage (VDDIN).

14. The method of claim 9, wherein the antifuse voltage generator (11b) further comprises:
a fourth transistor (T4) comprising:
a first terminal coupled to the second terminal of the first transistor (T1);
a second terminal coupled to the first terminal of the second transistor (T2); and
a control terminal configured to receive the driving voltage (VDDIN);
wherein the driving voltage (VDDIN) is greater than the second voltage (VSS);
and the method is further **characterized by** enabling the antifuse voltage generator (11b) during the reading operation, and when the antifuse voltage generator (11b) is enabled during the reading operation, the second voltage (VSS) is equal to a grounded voltage, the second control signal (BST) is equal to the grounded voltage, the inverse signal (ZBST) of the second control signal (BST) is equal to a fourth voltage (VDD) that is equal to 1 volt, the gate signal (G) is equal to the driving voltage (VDDIN) that is equal to 1 volt, and the antifuse control signal (AF) is equal to the driving voltage (VDDIN).

15. The method of claim 14, wherein the antifuse voltage generator (11b) further comprises:
a fourth transistor (T4) comprising:
a first terminal coupled to the second terminal of the first transistor (T1);
a second terminal coupled to the first terminal of the second transistor (T2); and
a control terminal configured to receive the driving voltage (VDDIN);
wherein the driving voltage (VDDIN) is greater than the second voltage (VSS); and the method is further **characterized by** enabling the antifuse voltage generator (11b) during the programming operation, and when the antifuse voltage generator (11b) is enabled during the programming operation, the second voltage (VSS) is equal to a grounded voltage, the second control signal (BST) is equal to the driving voltage (VDDIN) that is equal to 3.5 volts, the inverse signal (ZBST) of the second control signal (BST) is equal to a grounded voltage, the gate signal (G) is changed from the grounded voltage to the driving voltage (VDDIN) after the gate signal (G) is changed from the driving voltage (VDDIN) to the grounded voltage, and the antifuse control signal (AF) is equal to two times of the driving voltage (VDDIN).

## Patentansprüche

1. Speichersystem (100), **dadurch gekennzeichnet, dass** es umfasst:
einen Steuerblock (10), der umfasst:
einen Eingabeanschluss, der ausgestaltet ist ein Speicherdatensteuersignal (MCDS) zu erhalten;
einen ersten Ausgangsanschluss, der ausgestaltet ist, ein erstes Steuersignal (AS) auszugeben;
einen zweiten Ausgangsanschluss, der ausgestaltet ist, ein zweites Steuersignal (BST) auszugeben;
einen dritten Ausgangsanschluss, der ausgestaltet ist, ein drittes Steuersignal (C3) auszugeben; und
einen vierten Ausgangsanschluss, der ausgestaltet ist, ein viertes Steuersignal (C4) auszugeben;
einen Antisicherungs-Spannungsgenerator(11, 11a, 11b), der umfasst:
einen ersten Eingabeanschluss, der mit dem zweiten Ausgangsanschluss des Steuerblocks (10) gekoppelt und ausgestaltet ist, das zweite Steuersignal (BST) zu empfangen;
einen zweiten Eingabeanschluss, der ausgestaltet ist, eine treibende Spannung (VDDIN) zu empfangen;
einen Ausgangsanschluss, der ausgestaltet ist, ein Antisicherungs-Steuersignal (AF) auszugeben;
einen Oszillator (ROSC), der umfasst:
einen ersten Eingabeanschluss, der ausgestaltet ist, das zweite Steuersignal (BST) zu empfangen;
einen zweiten Eingabeanschluss, der ausgestaltet ist, die treibende Spannung (VDDIN) zu empfangen;
einen dritten Eingabeanschluss, der ausgestaltet ist, eine zweite Spannung (VSS) zu empfangen; und
einen Ausgangsanschluss, der ausgestaltet ist, ein Taktsignal (CLK) auszugeben;
einen Spannungsdoppler (VBOOST), der umfasst:
einen ersten Eingabeanschluss, der ausgestaltet ist, die treibende Spannung (VDDIN) zu empfangen;
einen zweiten Eingabeanschluss, der ausgestaltet ist, die zweite Spannung (VSS) zu empfangen;
einen dritten Eingabeanschluss, der mit dem Ausgangsanschluss des Oszillators (ROSC) gekoppelt und ausgestaltet ist, das Taktsignal (CLK) zu empfangen; und
einen Ausgangsanschluss, der ausgestaltet ist, während eines Programmiervorgangs das Antisicherungs-Steuersignal (AF) auszugeben;
einen ersten Transistor (T1), der umfasst:
einen ersten Anschluss, der ausgestaltet ist, die zweite Spannung (VSS) zu empfangen;
einen zweiten Anschluss; und
einen Steueranschluss, der ausgestaltet ist, ein inverses Signal (ZBST) des zweiten Steuersignals (BST) zu empfangen;
einen zweiten Transistor (T2), der umfasst:
einen ersten Anschluss, der mit dem zweiten Anschluss des ersten Transistors (T1) gekoppelt ist;
einen zweiten Anschluss, der mit dem Ausgangsanschluss des Spannungsdopplers (VBOOST) gekoppelt ist; und
einen Steueranschluss, der ausgestaltet ist, entsprechend dem zweiten Steuersignal (BST) ein Gattersignal (G) durch einen Logikschaltkreis (LC) zu empfangen; und
einen dritten Transistor (T3), der umfasst:
einen ersten Anschluss, der ausgestaltet ist, die treibende Spannung (VDDIN) zu empfangen;
einen zweiten Anschluss, der mit dem zweiten Anschluss des zweiten Transistors (T2) gekoppelt und ausgestaltet ist, während eines Lesevorgangs das Antisicherungs-Steuersignal (AF) auszugeben; und
einen Steueranschluss, der mit dem ersten Anschluss des zweiten Transistors (T2) gekoppelt ist;
worin die treibende Spannung (VDDIN) höher ist, als die zweite Spannung (VSS);
einen Array-Spannungsgenerator (12), der umfasst:
einen ersten Eingabeanschluss, der mit dem dritten Ausgangsanschluss des Steuerblocks gekoppelt und ausgestaltet ist, das dritte Steuersignal (C3) zu empfangen;
einen zweiten Eingabeanschluss, der ausgestaltet ist, die treibende Spannung (VDDIN) zu empfangen;
einen ersten Ausgangsanschluss, der ausgestaltet ist, ein Auswahlsignal (SL) auszugeben; und
einen zweiten Ausgangsanschluss, der ausgestaltet ist, ein folgendes Steuersignal (FL) auszugeben; und
einen Speicher-Array (13), der mit dem Steuerblock (10), dem Antisicherungs-Spannungsgenerator (11, 11a, 11b) und dem Array-Spannungsgenerator (12) gekoppelt und ausgestaltet ist, entsprechend dem ersten Steuersignal (AS), dem Antisicherungs-Steuersignal (AF), dem Auswahlsignal (SL), und dem folgenden Steuersignal (FL) auf Daten zuzugreifen, worin der Speicher-Array (13) mehrere Speicherzellen (MC1, MC2, MC3, MC4) umfasst, worin jede Speicherzelle (MC1) umfasst:
einen Programmierauswahl-Transistor (PST), der umfasst:
einen ersten Anschluss;
einen zweiten Anschluss, der ausgestaltet ist, ein Bitleitungs-Programmiersignal (BLP) zu empfangen; und
einen Steueranschluss, das ausgestaltet ist, ein Wortleitungs-Programmiersignal (WLP) zu empfangen;
einen Folgegatter-Transistor (FLT), der umfasst:
einen ersten Anschluss;
einen zweiten Anschluss, der mit dem erstem Anschluss des Programmierauswahl-Transistors (PST) gekoppelt ist; und
einen Steueranschluss, der ausgestaltet ist, das folgende Steuersignal (FL) zu empfangen;
ein Antisicherungs-Element (AFE), das umfasst:
einen ersten Anschluss, der ausgestaltet ist, das Antisicherungs-Steuersignal (AF) zu empfangen; und
einen zweiten Anschluss, der mit dem ersten Anschluss des
Folgegattertransistors (FLT) gekoppelt ist; und
einen Leseschaltkreis (RC), der mit dem zweiten Anschluss des Folgegatter-Transistors (FLT) gekoppelt und ausgestaltet ist, entsprechend einem Bitleitungs-Lesesignal (BLR), einem Wortleitungs-Lesesignal (WLR) und dem Auswahlsignal (SL) während eines Lesevorgangs der Speicherzelle (MC1) einen Lesestrom (IREAD) auszubilden, worin der Leseschaltkreis (RC) umfasst:
einen Lesetransistor (RT), der umfasst:
einen ersten Anschluss, der ausgestaltet ist, das Auswahlsignal (SL) zu empfangen;
einen zweiten Anschluss; und
einen Steueranschluss, der mit dem zweiten Anschluss des Folgegatter-Transistors (FLT) gekoppelt ist; und
einen Leseauswahl-Transistor (RST), der umfasst:
einen ersten Anschluss, der mit dem zweiten Anschluss des Lesetransistors (RT) gekoppelt ist;
einen zweiten Anschluss, der ausgestaltet ist, das Bitleitungs-Lesesignal (BLR) zu empfangen; und
einen Steueranschluss, der ausgestaltet ist, der Wortleitungs-Lesesignal (WLR) zu empfangen;
worin das erste Steuersignal (AS) Addressinformationen des Speicher-Arrays (13) umfasst.

2. Speichersystem (100) nach Anspruch 1, weiter **dadurch gekennzeichnet, dass** es einen Leseverstärker (14) umfasst, der mit dem vierten Ausgangsanschluss, des Steuerblocks (10) und dem Speicher-Array (13) gekoppelt und ausgestaltet ist, einen Bitleitungsstrom zu erfassen und mit einem Referenzstrom zu vergleichen.

3. Speichersystem (100) nach Anspruch 1, **dadurch gekennzeichnet, dass** das Antisicherungs-Element (AFE) ein Varaktor ist.

4. Speichersystem (100) nach Anspruch 1, **dadurch gekennzeichnet, dass** der Folgegatter-Transistor (FLT) durch ein natives Gerät, ein Kurzkanalgerät oder einen Varaktor durchgeführt wird.

5. Speichersystem (100) nach Anspruch 1, **dadurch gekennzeichnet, dass** der erste Transistor (T1) ein N-Typ-Metalloxid-Halbleiter-Feldeffekttransistor ist, und der zweite Transistor (T2) und der dritte Transistor (T3) P-Typ-Metalloxid-Halbleiter-FeldeffektTransistoren sind.

6. Speichersystem (100) nach Anspruch 1, **dadurch gekennzeichnet, dass** der Antisicherungs-Spannungsgenerator(11b) weiter umfasst:
einen vierten Transistor (T4), der umfasst:
einen ersten Anschluss, der mit dem zweiten Anschluss des ersten Transistors (T1) gekoppelt ist;
einen zweiten Anschluss, der mit dem ersten Anschluss des zweiten Transistors (T2) gekoppelt ist; und
einen Steueranschluss, der ausgestaltet ist, die treibende Spannung (VDDIN) zu empfangen;
worin die treibende Spannung (VDDIN) größer als die zweite Spannung (VSS) ist.

7. Speichersystem (100) nach einem der Ansprüche 1 und 6, **dadurch gekennzeichnet, dass** der Oszillator (ROSC) ein Ringoszillator ist.

8. Speichersystem (100) nach Anspruch 6, **dadurch gekennzeichnet, dass** der erste Transistor (T1) und der vierte Transistor (T4) N-Typ-Metalloxid-Halbleiter-Feldeffekttransistoren sind, und der zweite Transistor (T2) und der dritte Transistor (T3) P-Typ-Metalloxid-Halbleiter-Feldeffekttransistoren sind.

9. Verfahren zum Betreiben des Speichersystem (100) nach Anspruch 1, **dadurch gekennzeichnet, dass** während des Lesevorgangs der Speicherzelle (MC1) in dem Speicher-Array (13), das Bitleitungs-Programmiersignal (BLP) mit einer zweiten Spannung (0V) gleich 0 Volt und das Wortleitungs-Programmiersignal (WLP) mit der zweiten Spannung (0V) geliefert werden, das folgende Steuersignal (FL) bei einer ersten Spannung (VDD), das Antisicherungs-Steuersignal (AF) bei der ersten Spannung (VDD), das Bitleitungs-Lesesignal (BLR) bei der ersten Spannung (VDD), das Auswahlsignal (SL) bei der zweiten Spannung (0V) und das Wortleitungs-Lesesignal (WLR) bei der ersten Spannung (VDD) liegen, wobei die erste Spannung (VDD) größer als die zweite Spannung (0V) ist.

10. Verfahren nach Anspruch 9, **dadurch gekennzeichnet, dass** während eines Programmiervorgangs von Logik 1 auf die Speicherzelle (MC1) in dem Speicher-Array (13), das Bitleitungs-Programmiersignal (BLP) mit der ersten Spannung (VDD) geliefert wird, das Wortleitungs-Programmiersignal (WLP) bei der ersten Spannung (VDD), das folgende Steuersignal (FL) bei einem Spannungslevel zwischen der ersten Spannung (0V) und einer dritten Spannung (VPP), das Antisicherungs-Steuersignal (AF) bei der dritten Spannung (VPP), das Bitleitungs-Lese- (BLR) signal bei der ersten Spannung (VDD), das Auswahlsignal (SL) bei der ersten Spannung (VDD) und das Wortleitungs-Lesesignal (WLR) bei der ersten Spannung (VDD) liegen, wobei die dritte Spannung (VPP) größer als die erste Spannung (VDD) ist.

11. Verfahren nach Anspruch 9 oder 10, **dadurch gekennzeichnet, dass** während eines Programmiervorgang von Logik 0 auf die Speicherzelle (MC1) in den Speicher-Array (13), das Bitleitungs-Programmiersignal (BLP) mit der zweiten Spannung (0V) geliefert wird, das Wortleitungs-Programmiersignal (WLP) bei der ersten Spannung (VDD), das folgende Steuersignal (FL) bei einem Spannungslevel zwischen der ersten Spannung (VDD) und einer dritten Spannung (VPP), das Antisicherungs-Steuersignal (AF) bei der dritten Spannung (VPP), das Bitleitungs-Lese- (BLR) signal bei der ersten Spannung (VDD), das Auswahlsignal (SL) bei der ersten Spannung (VDD) und das Wortleitungs-Lesesignal (WLR) bei der ersten Spannung (VDD) liegen, worin die dritte Spannung (VPP) größer als die erste Spannung (VDD) ist.

12. Verfahren nach Anspruch 9, **dadurch gekennzeichnet, dass** der Antisicherungs-Spannungsgenerator (11a) während des Lesevorgangs aktiviert wird, wobei wenn der Antisicherungs-Spannungsgenerator (11a) während des Lesevorgangs aktiviert ist, die zweite Spannung (VSS) gleich einer Erdungsspannung ist, das zweite Steuersignal (BST) gleich der Erdungsspannung ist, das inverse Signal (ZBST) des zweiten Steuersignals (BST) gleich einer vierten Spannung (VDD) ist, die gleich 1 Volt ist, das Gattersignal (G) gleich der treibenden Spannung (VDDIN) ist, die gleich 1 Volt, ist und das Antisicherungs-Steuersignal (AF) gleich der treibenden Spannung (VDDIN) ist.

13. Verfahren nach Anspruch 9, **dadurch gekennzeichnet, dass** der Antisicherungs-Spannungsgenerator (11a) während des Programmiervorgangs aktiviert wird, wobei wenn der Antisicherungs-Spannungsgenerator(11a) während des Programmiervorgangs aktiviert wird, die zweite Spannung (VSS) gleich einer Erdungsspannung ist, das zweite Steuersignal (BST) gleich der treibenden Spannung (VDDIN) ist, die gleich 3,5 Volt ist, das inverse Signal (ZBST) des zweiten Steuersignals (BST) gleich einer Erdungsspannung ist, das Gattersignal (G) von der Erdungsspannung zu der treibenden Spannung (VDDIN) geändert wird, nachdem das Gattersignal (G) von der treibenden Spannung (VDDIN) zu der Erdungsspannung geändert wurde, wobei das Antisicherungs-Steuersignal (AF) gleich zweimal die treibende Spannung (VDDIN) ist.

14. Verfahren nach Anspruch 9, wobei der Antisicherungs-Spannungsgenerator(11b) weiter umfasst:
einen vierten Transistor (T4), der umfasst:
einen ersten Anschluss, der mit dem zweiten Anschluss des ersten Transistors (T1) gekoppelt ist;
einen zweiten Anschluss, der mit dem ersten Anschluss des zweiten Transistors (T2) gekoppelt ist; und
einen Steueranschluss, der ausgestaltet ist, die treibende Spannung (VDDIN) zu empfangen;
wobei die treibende Spannung (VDDIN) größer als die zweite Spannung (VSS) ist;
und wobei das Verfahren weiter **dadurch gekennzeichnet ist, dass** der Antisicherungs-Spannungsgenerator (11b) während des Lesevorgangs aktiviert wird, wobei wenn der Antisicherungs-Spannungsgenerator (11b) während des Lesevorgangs aktiviert wurde, die zweite Spannung (VSS) gleich einer Erdungsspannung ist, das zweite Steuersignal (BST) gleich der Erdungsspannung ist, das inverse Signal (ZBST) des zweiten Steuersignals (BST) gleich einer vierten Spannung (VDD) ist, die gleich 1 Volt ist, das Gattersignal (G) gleich der treibenden Spannung (VDDIN) ist, die gleich 1 Volt ist, und das Antisicherungs-Steuersignal (AF) gleich der treibenden Spannung (VDDIN) ist.

15. Verfahren nach Anspruch 14, worin der Antisicherungs-Spannungsgenerator(11b) weiter umfasst:
einen vierten Transistor (T4), der umfasst:
einen ersten Anschluss, der mit dem zweiten Anschluss des ersten Transistors (T1) gekoppelt ist;
einen zweiten Anschluss, der mit dem ersten Anschluss des zweiten Transistors (T2) gekoppelt ist; und
einen Steueranschluss, der ausgestaltet ist, die treibende Spannung (VDDIN) zu empfangen;
wobei die treibende Spannung (VDDIN) größer als die zweite Spannung (VSS) ist;
und wobei das Verfahren weiter **dadurch gekennzeichnet ist, dass** der Antisicherungs-Spannungsgenerator (11b) während des Programmiervorgangs aktiviert wird, wobei wenn der Antisicherungs-Spannungsgenerator (11b) während des Programmiervorgang aktiviert wurde, die zweite Spannung (VSS) gleich einer Erdungsspannung ist, das zweite Steuersignal (BST) gleich der treibenden Spannung (VDDIN) ist, die gleich 3,5 Volt ist, das inverse Signal (ZBST) des zweiten Steuersignals (BST) gleich einer Erdungsspannung ist, wobei das Gattersignal (G) von der Erdungsspannung zu der treibenden Spannung (VDDIN) geändert wird, nachdem das Gattersignal (G) von der treibenden Spannung (VDDIN) zu der Erdungsspannung geändert wurde, und wobei das Antisicherungs-Steuersignal (AF) gleich zweimal der treibenden Spannung (VDDIN) ist.

## Revendications

1. Système de mémoire (100), **caractérisé en ce qu'**il comprend :
un bloc de commande (10) comprenant :
une borne d'entrée configurée pour recevoir un signal de données de commande de mémoire (MCDS) ;
une première borne de sortie configurée pour délivrer en sortie un premier signal de commande (AS) ;
une deuxième borne de sortie configurée pour délivrer en sortie un deuxième signal de commande (BST) ;
une troisième borne de sortie configurée pour délivrer en sortie un troisième signal de commande (C3) ; et
une quatrième borne de sortie configurée pour délivrer en sortie un quatrième signal de commande (C4) ;
un générateur de tension antifusible (11, 11a, 11b) comprenant :
une première borne d'entrée couplée à la deuxième borne de sortie du bloc de commande (10) et configurée pour recevoir le deuxième signal de commande (BST) ;
une deuxième borne d'entrée configurée pour recevoir une tension d'excitation (VDDIN) ;
une borne de sortie configurée pour délivrer en sortie un signal de commande antifusible (AF) ;
un oscillateur (ROSC) comprenant :
une première borne d'entrée configurée pour recevoir le deuxième signal de commande (BST) ;
une deuxième borne d'entrée configurée pour recevoir la tension d'excitation (VDDIN) ;
une troisième borne d'entrée configurée pour recevoir une deuxième tension (VSS) ; et
une borne de sortie configurée pour délivrer en sortie un signal d'horloge (CLK) ;
un doubleur de tension (VBOOST) comprenant :
une première borne d'entrée configurée pour recevoir la tension d'excitation (VDDIN) ;
une deuxième borne d'entrée configurée pour recevoir la deuxième tension (VSS) ;
une troisième borne d'entrée couplée à la borne de sortie de l'oscillateur (ROSC) et
configurée pour recevoir le signal d'horloge (CLK) ; et
une borne de sortie configurée pour délivrer en sortie le signal de commande antifusible (AF) pendant une opération de programmation ;
un premier transistor (T1) comprenant :
une première borne configurée pour recevoir la deuxième tension (VSS) ;
une deuxième borne ; et
une borne de commande configurée pour recevoir un signal inverse (ZBST) du deuxième signal de commande (BST) ;
un deuxième transistor (T2) comprenant :
une première borne couplée à la deuxième borne du premier transistor (T1) ;
une deuxième borne couplée à la borne de sortie du doubleur de tension (VBOOST) ; et
une borne de commande configurée pour recevoir un signal de grille (G) par l'intermédiaire d'un circuit logique (LC) selon le deuxième signal de commande (BST) ; et
un troisième transistor (T3) comprenant :
une première borne configurée pour recevoir la tension d'excitation (VDDIN) ;
une deuxième borne couplée à la deuxième borne du deuxième transistor (T2) et configurée pour délivrer en sortie le signal de commande antifusible (AF) pendant une opération de lecture ; et
une borne de commande couplée à la première borne du deuxième transistor (T2) ;
dans lequel la tension d'excitation (VDDIN) est plus élevée que la deuxième tension (VSS) ; un générateur de tension de matrice (12) comprenant :
une première borne d'entrée couplée à la troisième borne de sortie du bloc de commande et configurée pour recevoir le troisième signal de commande (C3) ;
une deuxième borne d'entrée configurée pour recevoir la tension d'excitation (VDDIN) ;
une première borne de sortie configurée pour délivrer en sortie un signal de sélection (SL) ;
et une deuxième borne de sortie configurée pour délivrer en sortie un signal de commande suivant (FL) ;
et
une matrice mémoire (13) couplée au bloc de commande (10), au générateur de tension antifusible (11, 11a, 11b) et au générateur de tension de matrice (12) et configurée pour accéder à des données selon le premier signal de commande (AS), le signal de commande antifusible (AF), le signal de sélection (SL), et le signal de commande suivant (FL), la matrice mémoire (13) comprend une pluralité de cellules de mémoire (MC1, MC2, MC3, MC4), et chaque cellule de mémoire (MC1) comprend :
un transistor de sélection de programmation (PST) comprenant :
une première borne ;
une deuxième borne configurée pour recevoir un signal de programme de ligne de bits (BLP) ;
et
une borne de commande configurée pour recevoir un signal de programme de ligne de mots (WLP) ;
un transistor à grille suivant (FLT) comprenant :
une première borne ;
une deuxième borne couplée à la première borne du transistor de sélection de programmation (PST) ; et
une borne de commande configurée pour recevoir le signal de commande suivant (FL) ;
un élément antifusible (AFE) comprenant :
une première borne configurée pour recevoir le signal de commande antifusible (AF) ; et
une deuxième borne couplée à la première borne du transistor à grille suivant (FLT) ; et
un circuit de lecture (RC) couplé à la deuxième borne du transistor à grille suivant (FLT) et configuré pour former un courant de lecture (I_{READ}) selon un signal de lecture de ligne de bits (BLR), un signal de lecture de ligne de mots (WLR) et le signal de sélection (SL) pendant une opération de lecture de la cellule de mémoire (MCI), le circuit de lecture (RC) comprenant :
un transistor de lecture (RT) comprenant :
une première borne configurée pour recevoir le signal de sélection (SL) ;
une deuxième borne ; et
une borne de commande couplée à la deuxième borne du transistor à grille suivant (FLT) ; et
un transistor de sélection de lecture (RST) comprenant :
une première borne couplée à la deuxième borne du transistor de lecture (RT) ;
une deuxième borne configurée pour recevoir le signal de lecture de ligne de bits (BLR) ; et
une borne de commande configurée pour recevoir le signal de lecture de ligne de mots (WLR) ;
dans lequel le premier signal de commande (AS) comprend des informations d'adresse de la matrice mémoire (13).

2. Système de mémoire (100) selon la revendication 1, **caractérisé en outre en ce qu'**il comprend un amplificateur de détection (14) couplé à la quatrième borne de sortie du bloc de commande (10) et à la matrice mémoire (13) et configuré pour détecter et comparer un courant de ligne de bits à un courant de référence.

3. Système de mémoire (100) selon la revendication 1, **caractérisé en ce que** l'élément antifusible (AFE) est un varactor.

4. Système de mémoire (100) selon la revendication 1, **caractérisé en ce que** le transistor à grille suivant (FLT) est mis en œuvre par un dispositif natif, un dispositif à canal court ou un varactor.

5. Système de mémoire (100) selon la revendication 1, **caractérisé en ce que** le premier transistor (T1) est un transistor à effet de champ métal-oxyde-semi-conducteur de type N, et le deuxième transistor (T2) et le troisième transistor (T3) sont des transistors à effet de champ métal-oxyde-semi-conducteur de type P.

6. Système de mémoire (100) selon la revendication 1, **caractérisé en ce que** le générateur de tension antifusible (11b) comprend en outre :
un quatrième transistor (T4) comprenant :
une première borne couplée à la deuxième borne du premier transistor (T1) ;
une deuxième borne couplée à la première borne du deuxième transistor (T2) ; et
une borne de commande configurée pour recevoir la tension d'excitation (VDDIN) ;
dans lequel la tension d'excitation (VDDIN) est plus grande que la deuxième tension (VSS).

7. Système de mémoire (100) selon l'une ou l'autre des revendications 1 et 6, **caractérisé en ce que** l'oscillateur (ROSC) est un oscillateur en anneau.

8. Système de mémoire (100) selon la revendication 6, **caractérisé en ce que** le premier transistor (T1) et le quatrième transistor (T4) sont des transistors à effet de champ métal-oxyde-semi-conducteur de type N, et le deuxième transistor (T2) et le troisième transistor (T3) sont des transistors à effet de champ métal-oxyde-semi-conducteur de type P.

9. Procédé de fonctionnement du système de mémoire (100) selon la revendication 1, **caractérisé par** pendant l'opération de lecture de la cellule de mémoire (MC1) dans la matrice mémoire (13), la fourniture du signal de programme de ligne de bits (BLP) à une deuxième tension (0V) égale à 0 volt, le signal de programme de ligne de mots (WLP) à la deuxième tension (0V), le signal de commande suivant (FL) est à une première tension (VDD), le signal de commande antifusible (AF) est à la première tension (VDD), le signal de lecture de ligne de bits (BLR) est à la première tension (VDD), le signal de sélection (SL) est à la deuxième tension (0V), le signal de lecture de ligne de mots (WLR) est à la première tension (VDD), et la première tension (VDD) est supérieure à la deuxième tension (0V).

10. Procédé selon la revendication 9, **caractérisé en ce que** pendant une opération de programmation de logique 1 vers la cellule de mémoire (MC1) dans la matrice mémoire (13), fournissant le signal de programme de ligne de bits (BLP) à la première tension (VDD), le signal de programme de ligne de mots (WLP) est à la première tension (VDD), le signal de commande suivant (FL) est à un niveau de tension entre la première tension (0V) et une troisième tension (VPP), le signal de commande antifusible (AF) est à la troisième tension (VPP), le signal de lecture de ligne de bits (BLR) est à la première tension (VDD), le signal de sélection (SL) est à la première tension (VDD), le signal de lecture de ligne de mots (WLR) est à la première tension (VDD), et la troisième tension (VPP) est supérieure à la première tension (VDD).

11. Procédé selon la revendication 9 ou 10, **caractérisé en ce que** pendant une opération de programmation de logique 0 vers la cellule de mémoire (MC1) dans la matrice mémoire (13), fournissant le signal de programme de ligne de bits (BLP) à la deuxième tension (0V), le signal de programme de ligne de mots (WLP) est à une première tension (VDD), le signal de commande suivant (FL) est à un niveau de tension entre la première tension (VDD) et une troisième tension (VPP), le signal de commande antifusible (AF) est à la troisième tension (VPP), le signal de lecture de ligne de bits (BLR) est à la première tension (VDD), le signal de sélection (SL) est à la première tension (VDD), le signal de lecture de ligne de mots (WLR) est à la première tension (VDD), et la troisième tension (VPP) est supérieure à la première tension (VDD).

12. Procédé selon la revendication 9, **caractérisé par** l'activation du générateur de tension antifusible (11a) pendant l'opération de lecture, et lorsque le générateur de tension antifusible (11a) est activé pendant l'opération de lecture, la deuxième tension (VSS) est égale à une tension à la terre, le deuxième signal de commande (BST) est égal à la tension à la terre, le signal inverse (ZBST) du deuxième signal de commande (BST) est égal à une quatrième tension (VDD) qui est égale à 1 volt, le signal de grille (G) est égal à la tension d'excitation (VDDIN) qui est égale à 1 volt, et le signal de commande antifusible (AF) est égal à la tension d'excitation (VDDIN).

13. Procédé selon la revendication 9, **caractérisé par** l'activation du générateur de tension antifusible (11a) pendant l'opération de programmation, et lorsque le générateur de tension antifusible (11a) est activé pendant l'opération de programmation, la deuxième tension (VSS) est égale à une tension à la terre, le deuxième signal de commande (BST) est égal à la tension d'excitation (VDDIN) qui est égale à 3,5 volts, le signal inverse (ZBST) du deuxième signal de commande (BST) est égal à une tension à la terre, le signal de grille (G) est changé de la tension à la terre à la tension d'excitation (VDDIN) après que le signal de grille (G) est changé de la tension d'excitation (VDDIN) à la tension à la terre, et le signal de commande antifusible (AF) est égal à deux fois la tension d'excitation (VDDIN).

14. Procédé selon la revendication 9, dans lequel le générateur de tension antifusible (11b) comprend en outre :
un quatrième transistor (T4) comprenant :
une première borne couplée à la deuxième borne du premier transistor (T1) ;
une deuxième borne couplée à la première borne du deuxième transistor (T2) ; et
une borne de commande configurée pour recevoir la tension d'excitation (VDDIN) ;
dans lequel la tension d'excitation (VDDIN) est supérieure à la deuxième tension (VSS) ;
et le procédé est **caractérisé en outre par** l'activation du générateur de tension antifusible (11b) pendant l'opération de lecture, et lorsque le générateur de tension antifusible (11b) est activé pendant l'opération de lecture, la deuxième tension (VSS) est égale à une tension à la terre, le deuxième signal de commande (BST) est égal à la tension à la terre, le signal inverse (ZBST) du deuxième signal de commande (BST) est égal à une quatrième tension (VDD) qui est égale à 1 volt, le signal de grille (G) est égal à la tension d'excitation (VDDIN) qui est égale à 1 volt, et le signal de commande antifusible (AF) est égal à la tension d'excitation (VDDIN).

15. Procédé selon la revendication 14, dans lequel le générateur de tension antifusible (11b) comprend en outre :
un quatrième transistor (T4) comprenant :
une première borne couplée à la deuxième borne du premier transistor (T1) ; une deuxième borne couplée à la première borne du deuxième transistor (T2) ; et
une borne de commande configurée pour recevoir la tension d'excitation (VDDIN) ;
dans lequel la tension d'excitation (VDDIN) est supérieure à la deuxième tension (VSS) ;
et le procédé est **caractérisé en outre par** l'activation du générateur de tension antifusible (11b) pendant l'opération de programmation, et lorsque le générateur de tension antifusible (11b) est activé pendant l'opération de programmation, la deuxième tension (VSS) est égale à une tension à la terre, le deuxième signal de commande (BST) est égal à la tension d'excitation (VDDIN) qui est égale à 3,5 volts, le signal inverse (ZBST) du deuxième signal de commande (BST) est égal à une tension à la terre, le signal de grille (G) est changé de la tension à la terre à la tension d'excitation (VDDIN) après que le signal de grille (G) est changé de la tension d'excitation (VDDIN) à la tension à la terre, et le signal de commande antifusible (AF) est égal à deux fois la tension d'excitation (VDDIN).
